# FASCICULE DE BREVET EUROPEEN

(11) **EP 2 510 561 B1**
(45) Date de publication et mention de la délivrance du brevet: **01.07.2015**
(21) Numéro de dépôt: 10801626.2
(22) Date de dépôt: 03.12.2010
(51) Int. Cl.: C04B 35/622, C04B 35/626, H01L 41/37, H01L 37/02, H01L 41/18, B82Y 30/00

(54) **MATÉRIAU SOLIDE COMPOSITE PIÉZOÉLECTRIQUE ET/OU PYROÉLECTRIQUE, PROCÉDÉ D'OBTENTION ET UTILISATION D'UN TEL MATÉRIAU**
PIEZOELEKTRISCHER UND/ODER PYROELEKTRISCHER FESTSTOFFVERBUND, VERFAHREN ZU SEINER HERSTELLUNG UND VERWENDUNG EINES DERARTIGEN MATERIALS
PIEZOELECTRIC AND/OR PYROELECTRIC COMPOSITE SOLID MATERIAL, METHOD FOR OBTAINING SAME AND USE OF SUCH A MATERIAL

(30) Priorité: 11.12.2009 FR 0905995
(43) Date de publication de la demande: 17.10.2012
(73) Titulaire: Université Paul Sabatier Toulouse III, 31062 Toulouse Cedex 9 (FR)
(72) Inventeur: CAPSAL, Jean-Fabien, F-31000 Toulouse (FR); DAVID, Charlotte, F-31000 Toulouse (FR); DANTRAS, Eric, F-31500 Toulouse (FR); LACABANNE, Colette, F-31500 Toulouse (FR)
(74) Mandataire: Cabinet BARRE LAFORGUE & associés
(86) Numéro de dépôt international: PCT/FR2010/052609
(87) Numéro de publication internationale: WO 2011/070275

(56) Documents cités:
- US-A1- 2009 056 094
- OGUT E ET AL: "Poly(vinylidene fluoride)/zinc oxide smart composite material", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, vol. 6526, 2007, XP002588615, ISSN: 0277-786X
- FEENSTRA JOEL ET AL: "Enhanced active piezoelectric 0-3 nanocomposites fabricated through electrospun nanowires", JOURNAL OF APPLIED PHYSICS, AMERICAN INSTITUTE OF PHYSICS, US, vol. 103, no. 12, 19 June 2008 (2008-06-19), pages 124108-124108, XP012109054, ISSN: 0021-8979, DOI: 10.1063/1.2939271

## Description

L'invention concerne un matériau solide composite piézoélectrique et/ou pyroélectrique, un procédé d'obtention et l'utilisation d'un tel matériau.

L'invention trouve ses applications dans le domaine des transducteurs acoustiques, des résonateurs piézoélectriques, des capteurs de pression et/ou d'accélération, des actionneurs -notamment les actionneurs directs susceptibles de générer des courses de déplacement de 0,1 à 100 µm, en particulier pour la microscopie à force atomique et la microscopie à effet tunnel-, des moteurs piézoélectriques, des générateurs et transformateurs piézoélectriques, des capteurs pyroélectriques, des matériaux isolants phoniques -notamment de matériaux piézoélectriques anéchoïques- des matériaux à haute permittivité diélectrique -en particulier pour l'électronique et l'électrotechnique- et de matériaux actuateurs piézoélectriques.

On a déjà proposé d'incorporer des charges de particules micrométriques ou nanométriques d'un matériau ferroélectrique du type PZT (titano-zirconate de plomb), en particulier sous la forme de nanoparticules sphériques, c'est-à-dire de rapport de forme de l'ordre de 1, dans une matrice polyépoxy pour former un matériau composite piézoélectrique (*cf*, par exemple, « Furukawa et al., (1976), Japanese Journal of Applied Physics, 15 ; 11, 2119-2129 »). De telles nanoparticules sensiblement sphériques ne permettent pas d'atteindre dans le matériau composite un état de connectivité suffisamment élevé pour un taux de charge suffisamment faible et adapté pour préserver les propriétés mécaniques -résistance mécanique au choc, souplesse et ductilité- de la matrice.

On connait aussi l'utilisation de particules PMN-PT (Plomb/Magnésium/Niobium-Plomb/Titane) piézoélectriques de morphologie sensiblement sphérique (*cf,* par exemple, « Lam et al., (2005), Composite Science and Technology, 65, 1107-1111 ») dans une proportion volumique comprise entre 5% et 40% dans une matrice polymère. Un tel composite permet d'atteindre une valeur du coefficient piézoélectrique comprise entre 10 et 30 pC/N mais ne permet pas de conserver sensiblement la ductilité initiale de la matrice.

Des autres matériaux connus sont décrits par US 2009 / 0056094 A1 et par Erdem Ögütet al., "Poly(vinylidene fluoride)/Zinc Oxide Smart Composite Material", Behavior and Mechanics of Multifunctional and Composite Materials 2007, 19 March 2007, San Diego, CA, USA, Proceedings of the SPIE - The International Society for Optical Engineering, vol. 6526, p. 65260Q-1 - 65260Q-10, (2007).

Le problème qui se pose est donc celui d'obtenir un matériau solide composite de piézoélectricité et/ou de pyroélectricité élevée(s) -notamment d'efficacité piézoélectrique et/ou pyroélectrique supérieure aux matériaux composites piézoélectriques et/ou pyroélectriques de l'état de la technique-, mais sans toutefois dégrader sensiblement les propriétés mécaniques du matériau solide composite en comparaison des propriétés mécanique de la matrice constitutive dudit matériau solide composite.

En effet, une piézoélectricité et/ou une pyroélectricité maximale(s) est (sont) obtenue(s) au prix d'une quantité volumique supérieure à 25%, typiquement de l'ordre de 50%, qui modifie considérablement les propriétés mécaniques du matériau composite obtenu par rapport aux propriétés mécaniques de la matrice formant ledit matériau solide composite.

L'invention vise à pallier les inconvénients ci-dessus évoqués en proposant un matériau solide composite qui, d'une part, présente les avantages des matériaux composites vis-à-vis des matériaux ferroélectriques inorganiques (céramiques) en termes de propriétés mécaniques (notamment une plus grande légèreté pour une souplesse, une ductilité et une résistance aux chocs au moins équivalente -notamment supérieure-), mais qui, d'autre part, présente :
- une permittivité diélectrique (ε) la plus faible possible, notamment sensiblement inférieure à 20, et,
- un facteur de mérite piézoélectrique g₃₃ (d₃₃/ ε) supérieur à 45 mV.m/N, où d₃₃ est le coefficient piézoélectrique du matériau composite et/ou,
- un facteur de mérite pyroélectrique F (p/ ε) supérieur à 0,7 µC/K/m², où p est le coefficient pyroélectrique du matériau composite.

L'invention vise à proposer un tel matériau solide composite piézoélectrique et/ou pyroélectrique présentant un taux de charge réduit adapté pour préserver sensiblement les propriétés mécaniques dudit matériau solide composite.

L'invention vise en outre à proposer un tel matériau solide composite de masse volumique réduite pour une efficacité piézoéletrique et/ou pyroélectrique au moins conservée -notamment accrue-.

L'invention vise en outre un tel matériau solide composite piézoélectrique adapté pour permettre une déformation élastique augmentée sous une contrainte donnée et une réponse piézoélectrique augmentée pour ladite contrainte.

L'invention vise aussi un tel matériau solide composite conservant une réponse piézoélectrique et/ou pyroélectrique élevée pour une proportion de charge fonctionnelle réduite par rapport aux matériaux composites de l'état de la technique.

L'invention vise en particulier un matériau solide composite qui ne nécessite pas, contrairement aux matériaux piézoélectriques et/ou pyroélectriques organiques, l'application d'un champ électrique intense susceptible de provoquer un claquage diélectrique dudit matériau organique pour polariser ledit matériau piézoélectrique et/ou pyroélectrique organiques.

L'invention vise donc à proposer un matériau solide composite présentant simultanément des propriétés mécaniques comparables à celles des matériaux polymères de même nature, mais un facteur d₃₃ de mérite piézoélectrique supérieur à 45 mV.m/N.

L'invention vise aussi à proposer un matériau solide composite présentant simultanément des propriétés mécaniques comparables à celles des matériaux composites isolants de même nature, mais un facteur F de mérite pyroélectrique supérieur à 0,7 µC/K/m².

L'invention vise en outre à proposer un matériau solide composite présentant simultanément sensiblement la souplesse, la ductilité, la légèreté et la facilité de mise en oeuvre équivalentes à celles de la matrice polymère, mais aussi les propriétés électro-actives de la charge fonctionnelle inorganique.

L'invention vise aussi à proposer un tel matériau solide composite présentant des propriétés améliorées de dissipation d'énergie vibratoire, notamment d'énergie sonore, sous la forme de chaleur.

L'invention vise donc un matériau solide composite présentant en même temps les propriétés de ductilité, de résistance mécanique et de faible permittivité diélectrique des matériaux polymères organiques, tout en présentant les propriétés électro-actives des matériaux piézoélectriques et/ou pyroélectriques inorganiques et notamment une intensité faible du champ électrique nécessaire à sa polarisation.

Plus particulièrement, l'invention vise à proposer un matériau solide composite présentant une matrice solide (homogène ou composite) de matériau électriquement isolant, et un facteur d₃₃ de mérite piézoélectrique supérieur à 45 mV.m/N et/ou un facteur F de mérite pyroélectrique supérieur à 0,7 µC/K/m², les propriétés mécaniques finales du matériau solide composite selon l'invention étant au moins à 90% celles de la matrice solide.

L'invention vise en outre à proposer un matériau solide composite présentant un facteur d₃₃ de mérite piézoélectrique supérieur à 45 mV.m/N, mais dans lequel la surcharge massique liée à la charge fonctionnelle de nanoparticules piézoélectriques et/ou pyroélectriques dans le matériau solide composite n'excède pas sensiblement 50%.

L'invention vise aussi un procédé de fabrication d'un tel matériau solide composite qui soit simple peu couteux et rapide dans sa mise en oeuvre, qui ne nécessite pas d'équipement spécifique et préserve l'environnement.

L'invention vise aussi à proposer un tel procédé permettant la réalisation de pièces de formes quelconques avec des compositions de matériaux variables.

Pour ce faire, l'invention concerne un matériau, dit matériau hybride, solide composite piézoélectrique et/ou pyroélectrique comprenant :
- une matrice diélectrique solide,
- une charge inorganique répartie dans la matrice diélectrique solide, ladite charge inorganique étant constituée d'un matériau choisi dans le groupe formé des matériaux piézoélectriques, des matériaux pyroélectriques et des matériaux piézoélectriques et pyroélectriques, dans lequel ladite charge inorganique comprend des nanoparticules, dites nanoparticules filiformes, solides présentant :
   o une longueur, s'étendant selon une direction principale d'allongement des nanoparticules filiformes,
   o deux dimensions, dites dimensions orthogonales, s'étendant selon deux directions transversales orthogonales entre elles et orthogonales à ladite direction principale d'allongement des nanoparticules filiformes, lesdites dimensions orthogonales étant inférieures à ladite longueur et inférieures à 500 nm, et,
   o deux rapports, dits facteurs de forme, entre ladite longueur et chacune des deux dimensions orthogonales, lesdits facteurs de forme étant supérieurs à 10,
caractérisé en ce que lesdites nanoparticules filiformes sont réparties dans le volume de la matrice diélectrique solide avec une quantité en volume inférieure à 50%, notamment comprise entre 0,5% et 50%, préférentiellement comprise entre 5% et 20%, en particulier de l'ordre de 12%, et en ce que ;
les directions principales d'allongement des nanoparticules filiformes de la charge inorganique répartie dans la matrice diélectrique présentent une distribution sensiblement isotrope dans la matrice diélectrique solide.

Dans un matériau hybride selon l'invention, la matrice diélectrique solide peut être avantageusement formée d'au moins un matériau choisi dans le groupe des matériaux organiques -c'est-à-dire des matériaux constitués d'au moins un composé organique comprenant au moins une liaison covalente formée entre un atome de carbone et un atome distinct du carbone (en particulier l'hydrogène)-.

Dans un matériau hybride selon l'invention, la matrice diélectrique solide est préférentiellement formée d'un matériau organique polymère synthétique.

Avantageusement, la matrice diélectrique solide d'un matériau hybride selon l'invention comprend un matériau choisi dans le groupe des matériaux organiques constitués d'au moins un composé organique comprenant au moins un atome de silicium.

Avantageusement, la matrice diélectrique solide du matériau hybride selon l'invention est choisie dans le groupe formé des matrices diélectriques solides piézoélectriques, des matrices diélectriques solides pyroélectriques et des matrices diélectriques solides neutres du point de vue électrique.

Avantageusement et selon l'invention, la matrice diélectrique solide du matériau hybride est une matrice continue dans laquelle lesdites nanoparticules filiformes sont réparties dans tout le volume de ladite matrice diélectrique solide.

Avantageusement, la charge inorganique du matériau hybride selon l'invention est formée d'un composé métallique, non polymérique et ne comprenant pas de carbone.

Dans un matériau hybride selon l'invention, le facteur de forme d'une nanoparticule filiforme est le rapport entre la longueur de ladite nanoparticule filiforme, et l'une de ses deux dimensions orthogonales à ladite longueur. A titre d'exemple, un facteur de forme égal à 100 pour une nanoparticule filiforme de forme globalement cylindrique de révolution signifie que sa longueur est sensiblement égale à 100 fois son diamètre moyen. En tout état de cause, une nanoparticule filiforme est de forme globalement allongée dans laquelle les rapports de sa plus grande dimension (sa longueur) avec chacune des deux dimensions orthogonales sont supérieurs à 10.

Les inventeurs ont observé qu'un matériau hybride selon l'invention dans lequel la charge inorganique est formée de nanoparticules filiformes constituées d'un matériau piézoélectrique et/ou pyroélectrique, lesdites nanoparticules filiformes étant de haut facteur de forme et étant réparties dans le volume de la matrice diélectrique solide avec une quantité en volume inférieure à 50% permet une déformation en flexion des nanoparticules filiformes accrue, une séparation augmentée des charges du matériau piézoélectrique et/ou pyroélectrique de haut facteur de forme et un effet piézoélectrique et/ou pyroélectrique supérieur pour une même contrainte exercée sur ledit matériau hybride.

Avantageusement, les nanoparticules filiformes sont réparties dans le volume de la matrice diélectrique solide avec une quantité en volume inférieure à 35%, notamment comprise entre 1% et 35%, préférentiellement comprise entre 5% et 30%.

Plus particulièrement, un matériau hybride selon l'invention est avantageusement caractérisé par l'une au moins des caractéristiques suivantes :
- les deux dimensions orthogonales des nanoparticules filiformes sont comprises entre 50 nm et 500 nm -notamment de l'ordre de 200 nm-,
- les nanoparticules filiformes présentent deux facteurs de forme supérieurs à 10 -notamment supérieurs à 100, en particulier de l'ordre de 250-,
- les nanoparticules filiformes présentent une longueur supérieure à 1 µm, notamment comprise entre 2 µm et 50 µm, en particulier de l'ordre de 10 µm,
- les deux dimensions orthogonales des nanoparticules filiformes sont le diamètre de la section droite transversale des nanoparticules filiformes,
- la charge inorganique d'un matériau hybride selon l'invention est formée d'un matériau choisi dans le groupe formé des céramiques inorganiques piézoélectriques, des céramiques pyroélectriques et des céramiques piézoélectriques et pyroélectriques,
- la charge inorganique d'un matériau hybride selon l'invention est formée d'un matériau choisi dans le groupe des céramiques inorganiques -notamment des céramiques de type pérovskites-, par exemple du titanate de baryum de formule BaTiO₃, des titano-zirconates de plomb (PZT) de formule PbZrₓTi₁₋ₓO₃, du BaₓSr₁₋ₓTiO₃, du CaₓSr₁₋ₓTiO₃, le BaTiₓZr₁₋ₓO₃ où x est un nombre réel pouvant être nul, ou égal à 1, ou compris entre 0 et 1, du SrTiO₃, du BaZrO₃ du SrZrO₃, du PbTiO₃, du KNbO₃, du LiNbO₃, des PMN-PT (Pb/Mg/Nb-Pb/Ti), du dititanate de baryum (BaTi₂O₅) et du niobate (NaNbO₃),
- la matrice diélectrique solide du matériau hybride comprend au moins un matériau polymère choisi dans le groupe formé des matériaux polymères thermoplastiques et des matériaux polymères thermodurcissables,
- la matrice diélectrique solide du matériau hybride est formée d'un matériau polymère organique choisi dans le groupe formé des matériaux piézoélectriques, des matériaux pyroélectriques et des matériaux piézoélectriques et pyroélectriques. Par exemple, le matériau polymère organique de la matrice diélectrique solide est choisi dans le groupe formé du PVDF, du PVDF-TrFE, des terpolymères (copolymères formés de trois unités monomériques distinctes) fluorés, des polyamides impairs, du PEEK (polyéther-éthercétone), des polyamides pairs, des polyuréthanes et des silicones.

Avantageusement, le matériau hybride présente une valeur de permittivité diélectrique faible, notamment inférieure à 20 et un facteur de mérite piézoélectrique g₃₃ supérieur à 45 mV.m/N et/ou un facteur de mérite pyroélectrique F supérieur à 0,7 µC/K/m² et des propriétés mécaniques finales sensiblement conservées (notamment à plus de 90%) par rapport à la matrice diélectrique solide.

Avantageusement et selon l'invention, la charge inorganique est répartie de façon sensiblement uniforme dans la matrice diélectrique solide. Par répartition sensiblement uniforme de la charge inorganique dans la matrice diélectrique solide, on entend que la distance moyenne séparant les nanoparticules filiformes adjacentes est sensiblement constante dans la totalité du volume de la matrice diélectrique solide.

Avantageusement et selon l'invention, les nanoparticules filiformes sont choisies dans le groupe formé des nano-fils, des nano-bâtonnets et des nanotubes.

Dans une première variante d'un matériau hybride selon l'invention, une nanoparticule filiforme au sens de l'invention est un nano-bâtonnet ou un nano-fil. Dans cette première variante, les deux dimensions orthogonales d'une nanoparticule filiforme sont le diamètre de sa section droite transversale. Une nanoparticule filiforme peut aussi être un ruban dans lequel les deux dimensions orthogonales de la nanoparticule filiforme selon l'invention sont sa largeur (première dimension orthogonale) et son épaisseur (deuxième dimension orthogonale).

Dans une deuxième variante d'un matériau hybride selon l'invention les nanoparticules filiformes au sens de l'invention peuvent aussi être des nanotubes formés d'un cylindre creux présentant une épaisseur de paroi inférieure à 100 nm.

Avantageusement et selon l'invention, les nanoparticules filiformes étant des nanotubes, les nanoparticules filiformes présentent une paroi formant ledit nanotube d'épaisseur sensiblement inférieure à 100 nm.

Avantageusement et selon l'invention, les directions principales d'allongement des nanoparticules filiformes de la charge inorganique répartie dans la matrice diélectrique présentent une distribution sensiblement isotrope dans la matrice diélectrique solide. Par distribution sensiblement isotrope des directions principales d'allongement des nanoparticules filiforme dans la matrice diélectrique solide, on entend que les directions principales d'allongement des nanoparticules filiformes ne présentent pas en moyenne une orientation privilégiée dans la matrice diélectrique solide, mais au contraire s'étendent également dans toutes les directions.

Avantageusement, les nanoparticules filiformes réparties dans la matrice diélectrique présentent une distribution sensiblement homogène dans la matrice diélectrique solide.

En outre les inventeurs ont aussi noté qu'un tel matériau hybride dans lequel les nanoparticules de haut facteur de forme sont réparties de façon isotrope et homogène dans la matrice diélectrique solide dans une proportion volumique inférieure à 50% permet une déformabilité desdites nanoparticules et une connectivité entre lesdites nanoparticules qui sont suffisantes pour obtenir les effets piézo-électriques et/ou pyroélectriques requis. En particulier, les inventeurs ont observé qu'une telle proportion volumique de nanoparticules filiformes permet une connectivité suffisante entre les nanoparticules filiformes pour permettre une conduction par influence entre les nanoparticules filiformes pour une faible proportion desdites nanoparticules filiformes.

Avantageusement et selon l'invention, le matériau hybride comprend en outre une charge, dite charge conductrice, d'un matériau électriquement conducteur comprenant des nano-fils conducteurs présentant :
o une longueur, s'étendant selon une direction principale d'allongement des nano-fils conducteurs,
o deux dimensions, dites dimensions orthogonales, s'étendant selon deux directions transversales orthogonales entre elles et orthogonales à ladite direction principale d'allongement des nano-fils conducteurs, lesdites dimensions orthogonales étant inférieures à ladite longueur et inférieures à 500 nm, et,
o deux rapports, dits facteurs de forme, entre ladite longueur et chacune des deux dimensions orthogonales des nano-fils conducteurs, lesdits facteurs de forme étant supérieurs à 50,
dans lequel lesdits nano-fils conducteurs sont répartis dans le volume de la matrice diélectrique solide avec une quantité en volume inférieure à 1% -notamment sensiblement de l'ordre de 0,5%-.

En variante avantageusement et selon l'invention, un tel matériau hybride piézoélectrique et/ou pyroélectrique selon l'invention est caractérisé par l'une au moins des caractéristiques suivantes :
- les deux dimensions orthogonales des nano-fils conducteurs sont comprises entre 50 nm et 300 nm -notamment de l'ordre de 200 nm-,
- les nano-fils conducteurs présentent une longueur supérieure à 1 µm, notamment comprise entre 30 µm et 300 µm, en particulier de l'ordre de 50 µm,
- les deux dimensions orthogonales des nano-fils conducteurs sont le diamètre de la section droite transversale des nano-fils conducteurs,
- les nano-fils conducteurs présentent deux facteurs de forme supérieurs à 50 - notamment de l'ordre de 250-,
- les nano-fils conducteurs sont choisis dans le groupe formé des nano-bâtonnets et des nanotubes -notamment des nanotubes de carbone-,
- les nano-fils conducteurs sont formées d'un matériau choisi dans le groupe formé de l'or, de l'argent, du nickel, du cobalt, du cuivre et de leurs alliages, à l'état non oxydé,
- les nano-fils conducteurs sont formés d'un matériau métallique non oxydé,
- il comprend une quantité de nano-fils conducteurs comprise entre 0,1% et 1% en volume.

Avantageusement, la quantité de nano-fils conducteurs du matériau hybride est ajustée de manière à être inférieure, en valeur de fraction volumique, au seuil de percolation électrique dans la matrice diélectrique solide utilisée.

Avantageusement et selon l'invention, on utilise des nano-fils conducteurs dont les deux facteurs de forme sont supérieurs à 50, particulièrement compris entre 50 et 5000, plus particulièrement compris entre 100 et 1000, particulièrement et avantageusement de l'ordre de 250.

Avantageusement et selon l'invention, la proportion massique des nano-fils conducteurs par rapport à la matrice diélectrique solide est supérieure à 0,014%.

L'invention s'étend à un procédé d'obtention d'un matériau hybride selon l'invention.

L'invention concerne aussi un procédé d'obtention d'un matériau, dit matériau hybride, solide composite dans lequel on réalise une dispersion d'une charge inorganique comprenant des nanoparticules filiformes formées d'un matériau inorganique choisi dans le groupe formé des matériaux piézoélectriques, des matériaux pyroélectriques et des matériaux piézoélectriques et pyroélectriques -et éventuellement des nano-fils conducteurs-, lesdites nanoparticules filiformes présentant :
o une longueur, s'étendant selon une direction principale d'allongement des nanoparticules filiformes,
o deux dimensions, dites dimensions orthogonales, s'étendant selon deux directions transversales orthogonales entre elles et orthogonales à ladite direction principale d'allongement des nanoparticules filiformes, lesdites dimensions orthogonales étant inférieures à ladite longueur et inférieures à 500 nm, et,
o deux rapports, dits facteurs de forme, entre la longueur et chacune des deux dimensions orthogonales, lesdits facteurs de forme étant supérieur à 10,
dans une composition liquide précurseur d'une matrice diélectrique solide, de façon à obtenir une quantité en volume de nanoparticules filiformes dans ledit matériau hybride inférieure à 50% et de façon que les directions principales d'allongement des nanoparticules filiformes de la charge inorganique répartie dans la matrice diélectrique présentent une distribution sensiblement isotrope dans la matrice diélectrique solide.

Avantageusement et selon l'invention :
- on réalise la dispersion des nanoparticules filiformes -et éventuellement des nano-fils conducteurs- dans un milieu solvant liquide,
- on mélange cette dispersion dans la composition liquide précurseur,
- on élimine le solvant liquide, et,
on place le matériau hybride dans un champ électrique adapté pour permettre une polarisation des nanoparticules filiformes et leur conversion en nanoparticules filiformes piézoélectriques et/ou pyroélectriques.

On réalise cette étape de polarisation des nanoparticules filiformes du matériau hybride par des moyens, connus en soi de l'homme du métier, et adaptés pour permettre une conversion des nanoparticules filiformes en nanoparticules filiformes présentant à l'échelle macroscopique des propriétés piézoélectriques et/ou pyroélectriques.

Avantageusement et selon l'invention, la matrice diélectrique solide comprenant au moins un matériau polymère, la composition liquide précurseur est une solution dudit matériau polymère dans un solvant liquide choisi parmi le solvant de la dispersion de nanoparticules filiformes -et éventuellement des nano-fils conducteurs- et les solvants miscibles avec le solvant de la dispersion de nanoparticules filiformes. Avantageusement, la composition liquide précurseur est une solution diluée dudit matériau polymère dans le solvant liquide.

Avantageusement et selon l'invention, la matrice diélectrique solide comprenant au moins un matériau thermoplastique, la composition liquide précurseur est formée de la matrice diélectrique solide à l'état fondu. Avantageusement, la composition liquide précurseur est une solution condensée dudit matériau polymère.

Avantageusement, on réalise la dispersion de ladite charge inorganique comprenant des nanoparticules filiformes dans ladite composition liquide précurseur de la matrice diélectrique solide par tout moyen connu en lui-même de l'homme du métier, notamment par extrusion bi-vis.

Avantageusement et selon l'invention, la matrice diélectrique solide comprenant au moins un matériau thermodurcissable, la composition liquide précurseur est formée d'au moins une composition liquide entrant dans la composition du matériau thermodurcissable.

Avantageusement, on réalise une dispersion des nanoparticules filiformes -et éventuellement des nano-fils conducteurs- dans un solvant liquide, on mélange cette dispersion dans la composition liquide précurseur, et on élimine le solvant liquide. Ledit solvant liquide est de préférence choisi parmi les solvants non susceptibles d'oxyder les nano-fils conducteurs, ou de ne les oxyder que partiellement et de façon limitée.

En outre, avantageusement et selon l'invention, la matrice diélectrique solide comprenant au moins un matériau polymère, la composition liquide précurseur est une solution dudit matériau polymère dans un solvant liquide choisi parmi le solvant de la dispersion de nanoparticules filiformes, les solvants miscibles avec le solvant de la dispersion de nanoparticules filiformes. La dispersion de nanoparticules filiformes peut avantageusement être incorporée à ladite composition liquide précurseur au cours d'une étape de fabrication de la matrice diélectrique solide.

Par ailleurs, avantageusement et selon l'invention, on soumet la dispersion des nanoparticules filiformes dans la composition liquide précurseur aux ultrasons.

En outre, avantageusement, dans un procédé selon l'invention, on utilise des nanoparticules filiformes -et éventuellement des nano-fils conducteurs- selon l'une au moins des caractéristiques mentionnées ci-dessus.

Avantageusement et selon l'invention, l'intensité du champ électrique appliqué au matériau hybride est comprise entre 1 kV/mm et 10 kV/mm.

L'invention s'étend aussi à l'utilisation d'un tel matériau hybride pour la réalisation de pièces structurelles et de films supportés déposés sur tout ou partie de la surface d'un tel support.

En particulier on utilise un tel matériau hybride selon l'invention pour permettre :
- la détection d'une contrainte mécanique en surface dudit matériau hybride par effet piézoélectrique direct, ou,
- la détection d'une variation de température en surface dudit matériau hybride par effet pyroélectrique direct.

Dans une variante selon l'invention, on utilise un tel matériau hybride dans des applications visant, par exemple, un capteur/convertisseur énergétique pour la création d'une onde mécanique statique ou dynamique par effet piézoélectrique inverse dans des applications visant :
o un dispositif audio flexible, et/ou
o un actionneur mécanique, et/ou
o un dispositif de dégivrage et/ou
o un dispositif antisalissure mécanique, aussi appelé dispositif « antifouling ».

Dans une autre variante selon l'invention, on utilise un tel matériau hybride dans des applications visant un matériau isolant phonique -notamment un matériau anéchoïque- adapté pour permettre une absorption d'une onde vibratoire audible et la dissipation de l'énergie de ladite onde vibratoire par effet Joule, à l'échelle locale, *via* les nano-fils conducteurs.

L'invention concerne également un matériau composite, un procédé d'obtention d'un tel matériau composite et l'utilisation d'un tel matériau solide composite piézoélectrique et/ou pyroélectrique caractérisés en combinaison par tout ou partie des caractéristiques mentionnées ci-dessus ou ci-après.

D'autres buts, caractéristiques et avantages de l'invention apparaîtront à la lecture de la description suivante, qui se réfère aux exemples donnés à titre non limitatif et aux figures annexées, dans lesquelles :
- la figure 1 est un schéma synoptique descriptif d'un procédé de fabrication d'un matériau hybride piézoélectrique et/ou pyroélectrique selon l'invention,
- la figure 2 est une vue schématique en coupe transversale d'un matériau hybride piézoélectrique et/ou pyroélectrique selon l'invention,
- la figure 3 est une vue schématique en coupe transversale d'une variante d'un matériau hybride piézoélectrique et/ou pyroélectrique selon l'invention.

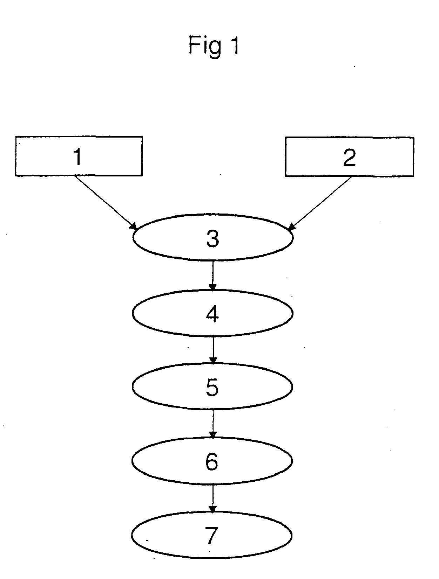

Dans un procédé selon l'invention représenté figure 1, on utilise des nanoparticules 1 filiformes -c'est-à-dire de haut facteur de forme-formées d'un matériau solide piézoélectrique et/ou pyroélectrique et/ou ferroélectrique. On obtient un tel matériau par un procédé connu en soi de l'homme du métier, notamment par dépôt en phase vapeur ou par voie chimique en présence de ligands de coordination comme décrit, par exemple, dans « Urban et al, (2001), Journal of the American Chemical Society, 124(7), 1186-1187 ». En particulier, un tel procédé de fabrication de nanoparticules filiformes piézoélectriques, pyroélectriques par un procédé d'électrodéposition dans les canaux d'une membrane poreuse est décrit à l'exemple 1 suivant.

On réalise une dispersion 3 des nanoparticules 1 filiformes piézoélectriques et/ou pyroélectriques dans une solution 2 liquide précurseur d'une matrice 11 diélectrique solide. On réalise cette dispersion 3 par des moyens connus en eux-mêmes de l'homme du métier, notamment par mélange mécanique ou par traitement par les ultrasons. En particulier, ces moyens de dispersion sont adaptés pour former une répartition isotrope des nanoparticules 1 filiformes dans la solution 2 liquide précurseur d'une matrice 11 diélectrique solide et dans la matrice 11 diélectrique solide. La solution 2 liquide précurseur de la matrice 11 diélectrique solide peut être une solution d'un polymère thermoplastique dans un milieu solvant dudit polymère.

On forme le matériau hybride selon l'invention par évaporation 4 du milieu solvant liquide à une température supérieure à la température de vaporisation dudit milieu solvant liquide. On obtient un matériau hybride formé de nanoparticules 1 filiformes dispersées de façon homogène et isotrope dans la matrice 11 diélectrique solide.

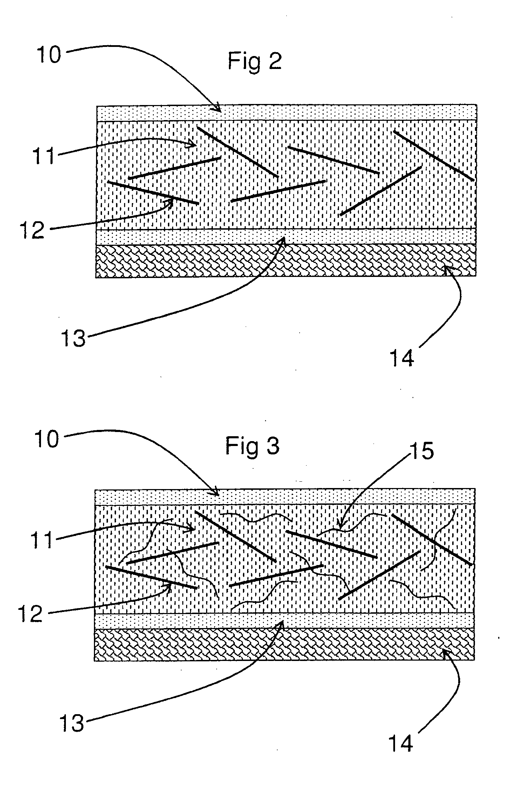

On réalise ensuite une étape 5 de formage dudit matériau hybride, notamment par thermoformage du matériau thermoplastique obtenu, adaptée pour permettre la formation d'une plaque dudit matériau hybride, d'un film de faible épaisseur dudit matériau hybride ou encore d'une couche dudit matériau hybride formant la surface d'un support 14. La surface extérieure du support 14 peut être de forme quelconque, mais dans le mode de réalisation représenté en figure 2 et en figure 3, la surface extérieure du support 14 est plane.

On équipe ensuite, par apposition 6, le matériau hybride de deux plaques 10, 13 électriquement conductrices formant deux électrodes au contact des deux faces principales du matériau hybride et on applique entre ces deux électrodes, une différence de potentiel adaptée pour permettre une polarisation 7 du matériau solide composite. Ces deux électrodes 10, 13 sont en outre adaptées pour permettre le transfert d'énergie électrique à partir du matériau solide composite pour un effet piézoélectrique direct ou un effet pyroélectrique direct. Ces deux électrodes 10, 13 sont aussi adaptées pour le transfert d'énergie électrique vers le matériau hybride pour un effet piézoélectrique inverse.

En variante non représentée, il est aussi possible que la solution 2 liquide précurseur d'une matrice 11 diélectrique solide soit constituée de l'un seul des composants nécessaires à la polymérisation d'une matrice 11 diélectrique solide thermodurcissable. Dans ce cas la formation de la matrice 11 diélectrique solide est obtenue par addition ultérieure de l'autre des composants nécessaires à la polymérisation de la matrice 11 diélectrique solide thermodurcissable préalablement à l'étape 5 de formage dudit matériau hybride. Un matériau hybride selon l'invention représenté en figure 2 comprend des nanoparticules 12 filiformes piézoélectriques et/ou pyroélectriques de titanate de baryum de haut facteur de forme distribuées de façon homogène et isotrope dans une matrice 11 diélectrique solide thermodurcissable. Les nanoparticules 12 filiformes de titane de baryum présentent une longueur moyenne sensiblement de l'ordre de 10 µm, un diamètre moyen sensiblement de l'ordre de 200 nm et une facteur de forme de l'ordre de 50.

Dans une utilisation d'un matériau hybride selon l'invention pour des applications piézoélectriques directes ou inverses et des applications pyroélectriques directes, le matériau hybride forme un contact électrique avec un substrat 14 polymère flexible préalablement revêtu d'une électrode 13 conductrice. Le matériau hybride piézoélectrique et/ou pyroélectrique peut, en outre, être utilisé sous la forme d'une pastille à apposer sur ledit substrat 14 polymère.

Un matériau hybride selon l'invention représenté en figure 3 comprend des nanoparticules 12 filiformes piézoélectriques et/ou pyroélectriques de titanate de baryum de haut facteur de forme et des nanoparticules 15 électriquement conductrices distribuées de façon homogène et isotrope dans une matrice 11 diélectrique solide thermodurcissable. Les nanoparticules 15 électriquement conductrices sont choisies parmi les nanoparticules conductrices, les nano-fils conducteurs ou les nanotubes de carbone. La fraction de nanoparticules 15 électriquement conductrices est ajustée de manière à être inférieure, en valeur de fraction volumique, au seuil de percolation électrique (au-delà duquel les nanoparticules 15 électriquement conductrices forment un continuum électriquement conducteur dans la matrice 11 diélectrique) dans la matrice 11 diélectrique solide utilisée. Le matériau hybride réalisé à partir d'une matrice 11 thermoplastique est thermoformé sur un substrat solide. Le matériau hybride réalisé à partir d'une matrice 11 thermodurcissable est polymérisé sur un substrat solide préalablement métallisé sur la surface adressée.

Dans le cas ou la charge fonctionnelles du matériau hybride est composée de nanoparticules 12 filiformes piézoélectriques et/ou pyroélectriques et de nanoparticules 15 électriquement conductrices, les vibrations appliquées au substrat se propagent dans le matériau hybride piézoélectrique. Les ondes mécaniques sont converties en énergie électrique *via* les nanoparticules 12 filiformes piézoélectriques de haut facteur de forme et les charges électriques ainsi créées sont évacuées par les nanoparticules 15 électriquement conductrices. L'onde de propagation mécanique et les vibrations du substrat sont ainsi amorties *via* la conversion par effet piézoélectrique inverse des nanoparticules à haut facteur de forme de titanate de baryum.

EXEMPLE 1 : Préparation de nano-fils de titanate de baryum de haut facteur de forme.

On synthétise des nano-fils de BaTiO₃ par électrodéposition d'une solution aqueuse de titanate de baryum dans les pores d'une membrane de filtration en alumine (PAA, *Porous Anodised Alumina,* Whatmann, Réf 6809-5022 ou 6809-5002) de 50 µm d'épaisseur et dont la porosité est de 200 nm. On réalise le sol de titanate de baryum par dissolution de 3 g d'acétate de baryum (Ref. 255912, Sigma-Aldrich, Lyon, France) et de 3,3 g d'isopropoxyde de titane (Ref. 377996, Sigma-Aldrich, Lyon, France) dans 20,16 mL d'acide acétique glacial (Ref. A9967, Sigma-Aldrich, Lyon, France) en présence de 3,27 mL d'éthylène glycol (Ref. 324558, Sigma-Aldrich, Lyon, France) et de 2 L d'eau. Le pH final du sol préparé est de 5. On dispose la membrane de filtration dans le sol de titanate de baryum de façon que l'une des faces principale de la membrane de filtration forme un contact étanche avec la surface d'une plaque d'aluminium préalablement revêtue d'une couche conductrice d'argent et formant la cathode du dispositif d'électrodéposition. L'anode du dispositif est formée d'un fil de métal pur -par exemple d'or ou de platine- s'étendant en regard de la surface opposée de la membrane de filtration et plongeant dans le sol de titanate de baryum.

On applique entre la cathode et l'anode une tension de 5 V de façon que l'intensité initiale du courant électrique soit proche de 150 µA. On dépose ainsi dans les pores de la membrane poreuse, le sol de titanate de baryum. On réalise, après l'étape d'électrodéposition, une étape de traitement thermique de recuit des nano-fils de titanate de baryum à une température de l'ordre de 600°C dans l'air atmosphérique de façon à former les nano-fil de céramique.

On dissout la membrane poreuse par traitement dans une solution aqueuse de soude à une concentration de 48 g/L. Au bout de 15 min de traitement, les nano-fils céramiques de titanate de baryum à haut facteur de forme sont libérés dans la solution alcaline. Les nano-fils sont séparés de la solution alcaline, lavés et conservés dans un solvant organique, par exemple la N,N-diméthylacétamide (CH3-CO-N(CH₂)₂, Ref. D5511, Sigma-Aldrich, Lyon, France). Ces nano-fils céramiques de titanate de baryum présentent un diamètre moyen de l'ordre de 200 nm et une longueur moyenne de l'ordre de 50 µm pour un rapport longueur sur diamètre (facteur de forme) sensiblement proche de 250.

EXEMPLE 2 : Préparation de nanotubes de titanate de baryum de haut facteur de forme.

On prépare un sol de BaTiO₃ tel que décrit à l'exemple 1. On dépose ce sol de BaTiO₃ sur l'une des surfaces principales d'une membrane de filtration en alumine (PAA) de 50 µm d'épaisseur et dont la porosité est de 200 nm et de façon à former une couche d'enduction de la surface intérieure des pores de ladite membrane de filtration. On sèche la membrane poreuse à la température de 100°C puis on réalise une étape de traitement thermique de recuit des nanotubes de BaTiO₃ à une température de l'ordre de 600°C dans l'air atmosphérique. On réalise une attaque alcaline de la membrane poreuse puis un lavage comme décrit à l'exemple 1 de façon à former une suspension des nanotubes de BaTiO₃ dans un solvant organique, par exemple la N,N-diméthylacétamide.

EXEMPLE 3 - Préparation d'un matériau composite hybride piézoélectrique et/ou pyroélectrique formé de nano-fils de BaTiO₃ dispersés dans une matrice 11 diélectrique thermoplastique de polyamide 11.

On disperse 250 mg de nano-fils de BaTiO₃ ayant un facteur de forme de 25, tels que décrits à l'exemple 1, dans 20 mL de N,N-diméthylacétamide. On soumet cette dispersion à un traitement de dispersion dans un bain à ultrasons de fréquence sensiblement de l'ordre de 20 kHz, pour une puissance dispersée de l'ordre de 500 W. D'autre part on solubilise 250 mg de Polyamide 11 (PA11, Rilsan^{®} polyamide 11, ARKEMA, USA) dans 20 mL de N,N-diméthylacétamide. On homogénéise le mélange par traitement aux ultrasons. Après évaporation de la N,N-diméthylacétamide et thermoformage à chaud, on obtient un film composite hybride de 150 µm d'épaisseur dont la charge en nanoparticules filiforme de BaTiO₃ dans la matrice de polyamide 11 est de 12% en volume.

En variante, on dépose ce film de matériau composite hybride sous la forme d'une pastille en surface d'un substrat à température ambiante ou alors on le forme par traitement thermique sur la surface d'un substrat électriquement conducteur.

On place une électrode sur chacune des deux faces principales du film de matériau composite hybride obtenu et on soumet le matériau composite hybride à un traitement de polarisation par application d'un champ électrique d'une intensité de 3 kV/mm à une température de 100°C pendant 30 minutes.

On obtient un matériau composite hybride selon l'invention présentant une permittivité diélectrique proche de 5, une valeur du facteur F de mérite pyroélectrique supérieur à 0,7 µC/K/m² et une valeur du facteur g₃₃ de mérite piézoélectrique supérieur à 45 mV.m/N tout en conservant sensiblement la ductilité mécanique de la matrice polyamide 11.

L'application d'une contrainte mécanique en compression sur la surface du composite solide ou en torsion induit la variation du dipôle macroscopique du matériau solide composite. Ces matériaux peuvent donc être utilisés en tant que capteurs de chocs ou de déformation ou dans des systèmes de conversion d'énergie mécanique en énergie électrique.

L'application d'une variation de température en surface du matériau solide composite hybride selon l'invention induit la variation du dipôle macroscopique dudit matériau solide composite. Ces matériaux peuvent donc être avantageusement utilisés en tant que capteurs thermiques ou dans des systèmes de conversion d'énergie thermique en énergie électrique.

L'application d'une tension électrique, continue ou alternative, sur les deux faces principales du matériau solide composite hybride selon l'invention induit la déformation dudit matériau générant une contrainte de surface. Ces matériaux peuvent donc avantageusement être utilisés en tant que transducteur d'énergie électrique en énergie mécanique.

EXEMPLE 4 - Préparation d'un matériau solide composite hybride piézoélectrique et/ou pyroélectrique formé de nano-fils de BaTiO₃ dans une matrice thermodurcissable de poly-uréthane.

On disperse 132 mg de nano-fils de céramique (BaTiO₃) ayant un facteur de forme de 25, tels que décrits à l'exemple 1, dans 100 mg de résine acrylique (Mapaero, Pamiers, France). La suspension de nano-fils de céramique dans la résine acrylique est soumise aux ultrasons à une fréquence de 50 kHz sous une puissance de 500 W. On introduit 32 mg d'isocyanate (Mapaero, Pamiers, France) dans la suspension. On homogénéise le mélange sous ultrasons. Cette solution est ensuite déposée sur un substrat électriquement conducteur. Après polymérisation on obtient un film composite solide hybride piézoélectrique et pyroélectrique de 100 µm d'épaisseur et chargé à 12% en volume.

On place une électrode sur la face principale du film composite solide hybride opposée au substrat électriquement conducteur et on applique sur ledit composite solide hybride un champ électrique de 3 kV/mm à une température de 100°C pendant 30 minutes. On obtient ainsi par polarisation un matériau composite solide hybride présentant une permittivité diélectrique proche de 5, un facteur F de mérite pyroélectrique supérieur à 0,7 µC/K/m² et un facteur g₃₃ de mérite piézoélectrique supérieur à 45 mV.m/N.

A titre d'exemple descriptif d'un matériau électro-actif de l'état de la technique, à comparer aux caractéristiques d'un matériau composite solide hybride selon l'invention décrit dans les exemples 3 et 4, une céramique de titanate de baryum présente une valeur du facteur F de mérite pyroélectrique de 0,15 µC/K/m², une valeur du facteur g₃₃ de mérite piézoélectrique de 15 mV.m/N. Une telle céramique ferroélectrique de titanate de baryum présente est de grande fragilité mécanique.

L'application d'une contrainte mécanique en surface du matériau solide composite hybride induit la variation du dipôle macroscopique du matériau solide composite. Ces matériaux peuvent donc être utilisés en tant que capteurs de chocs ou de déformation ou dans des systèmes de conversion d'énergie mécanique en énergie électrique.

L'application d'une variation de température en surface du matériau solide composite hybride induit la variation du dipôle macroscopique dudit matériau. Un tel matériau peut donc avantageusement être utilisé en tant que capteurs thermiques ou dans des systèmes de conversion d'énergie thermique en énergie électrique.

EXEMPLE 5 : Préparation d'un dispositif acoustique flexible à partir d'un composite formé de nano-fils piézoélectrique de haut facteur de forme dispersés dans une matrice polymère.

Un matériau hybride selon l'invention est fabriqué selon l'exemple 3. Le matériau hybride réalisé à partir d'une matrice polyamide 11 thermoplastique est thermoformé sur un substrat flexible polymère (polyéthylène) d'une épaisseur de 70 µm et d'une dimension de 1 m x 1 m.

Il est possible d'ajuster l'impédance électrique du matériau hybride appliqué sur le substrat en faisant varier l'épaisseur de la couche dudit matériau et l'aire de la surface de dépôt du matériau hybride de telle sorte que l'impédance électrique du matériau hybride soit adaptée à l'impédance électrique du générateur de tension.

On applique une tension de 5V et une fréquence variable comprise entre 500 Hz et 20 kHz sur les deux faces principales du matériau solide composite hybride selon l'invention. La déformation du matériau solide composite hybride et du substrat sous l'action du champ électrique induit à la surface du dispositif acoustique, une contrainte de fréquence égale à la fréquence du champ appliqué et générant un son audible.

De part la conservation de la ductilité de la matrice du solide composite et du substrat polymère ainsi que de la faible consommation électrique de ce système, ce dispositif acoustique flexible est une alternative à l'utilisation des baffles électromagnétiques conventionnelles.

EXEMPLE 6 : Préparation d'un dispositif acoustique flexible à partir d'un matériau hybride formé de nano-fils piézoélectrique de haut facteur de forme dispersés dans une matrice polyuréthane thermodurcissable.

Un matériau solide composite hybride selon l'invention est fabriqué selon l'exemple 4. Le matériau solide composite hybride réalisé à partir d'une matrice polyuréthane thermodurcissable est appliqué aux fins de sa polymérisation sur un substrat flexible en polyéthylène d'une épaisseur de 70 µm et d'une dimension de 1 m x 1 m et préalablement métallisé sur sa surface d'application dudit matériau solide composite hybride. On obtient un dispositif acoustique selon l'invention selon un procédé tel que décrit dans l'exemple 5.

EXEMPLE 7 : Préparation d'un matériau solide composite hybride piézoélectrique et/ou pyroélectrique formé de nano-fils de NaNbO₃ dans une matrice thermoplastique polyamide

On synthétise des nanofils de niobate de sodium NaNbO₃ par dissolution de 1 g de pentoxyde de niobium dans 60 mL d'hydroxyde de sodium à une concentration de 10 mM et traitement de la solution obtenue dans un autoclave d'une contenance de 25 mL à une température de 180°C pendant 8 heures. On obtient des nanoparticules filiformes (nanofils) présentant un facteur de forme supérieur à 30 et une structure cristalline non centro-symétrique de type orthorhombique.

On mélange 100 mg de nanofils de NaNbO₃ avec 20 mL de N,N-diméthylacétamide. La suspension obtenue est soumise à un traitement par ultrasons (fréquence de l'ordre de 20 kHz) pour une puissance dispersée de l'ordre de 500 W. On solubilise par ailleurs 200 mg de polyamide 11 dans 20 mL de N,N-diméthylacétamide. On mélange la solution contenant les nanofils de NaNbO₃ et la solution de polyamide 11 et on homogénéise le mélange obtenu sous ultrasons. On évapore la N,N-diméthylacétamide. On réalise une étape de thermoformage à chaud du matériau composite solide de façon à former un film composite d'une épaisseur comprise entre 30 µm et 1 mm. La fraction volumique de la phase inorganique dans la matrice diélectrique est de 10%.

On dépose sur chacune des faces principales du film composite, une électrode électriquement conductrice et on applique un champ électrique de 10 kV/mm à une température de 130°C et pendant 10 mn. On obtient un film composite piézoélectrique et/ou pyroélectrique présentant des propriétés piézoélectrqies et/ou pyroélectriques dans une gamme de température comprise entre -100°C et+180°C.

## Revendications

1. Matériau, dit matériau hybride, solide composite piézoélectrique et/ou pyroélectrique comprenant :
- une matrice (11) diélectrique solide,
- une charge inorganique répartie dans la matrice (11) diélectrique solide, ladite charge inorganique étant constituée d'un matériau choisi dans le groupe formé des matériaux piézoélectriques, des matériaux pyroélectriques et des matériaux piézoélectriques et pyroélectriques,
dans lequel ladite charge inorganique comprend des nanoparticules, dites nanoparticules (12) filiformes, solides présentant :
o une longueur, s'étendant selon une direction principale d'allongement des nanoparticules (12) filiformes,
o deux dimensions, dites dimensions orthogonales, s'étendant selon deux directions transversales orthogonales entre elles et orthogonales à ladite direction principale d'allongement des nanoparticules (12) filiformes, lesdites dimensions orthogonales étant inférieures à ladite longueur et inférieures à 500 nm, et,
o deux rapports, dits facteurs de forme, entre ladite longueur et chacune des deux dimensions orthogonales, lesdits facteurs de forme étant supérieurs à 10,
dans lequel
- lesdites nanoparticules (12) filiformes sont réparties dans le volume de la matrice (11) diélectrique solide avec une quantité en volume inférieure à 50%, et en ce que ;
- les directions principales d'allongement des nanoparticules (12) filiformes de la charge inorganique répartie dans la matrice (11) diélectrique présentent une distribution sensiblement isotrope dans la matrice (11) diélectrique solide.

2. Matériau selon la revendication 1, **caractérisé en ce que** la charge inorganique est répartie de façon sensiblement uniforme dans la matrice (11) diélectrique solide.

3. Matériau selon l'une des revendications 1 ou 2, **caractérisé en ce que** les nanoparticules (12) filiformes sont choisies dans le groupe formé des nano-fils, des nano-bâtonnets et des nanotubes.

4. Matériau selon l'une des revendications 1 à 3, **caractérisé en ce que** la charge inorganique est formée d'un matériau, choisi dans le groupe des céramiques inorganiques.

5. Matériau selon d'une des revendications 1 à 4, **caractérisé en ce que** la matrice (11) diélectrique solide comprend au moins un matériau polymère choisi dans le groupe formé des matériaux polymères thermoplastiques et des matériaux polymères thermodurcissables.

6. Matériau selon l'une des revendications 1 à 5, **caractérisé en ce qu'**il comprend en outre une charge, dite charge conductrice, d'un matériau électriquement conducteur comprenant des nano-fils (15) conducteurs présentant :
o une longueur, s'étendant selon une direction principale d'allongement des nano-fils (15) conducteurs,
o deux dimensions, dites dimensions orthogonales, s'étendant selon deux directions transversales orthogonales entre elles et orthogonales à ladite direction principale d'allongement des nano-fils (15) conducteurs, lesdites dimensions orthogonales étant inférieures à ladite longueur et inférieures à 500 nm, et,
o deux rapports, dits facteurs de forme, entre ladite longueur et chacune des deux dimensions orthogonales des nano-fils (15) conducteurs, lesdits facteurs de forme étant supérieurs à 50,
dans lequel lesdits nano-fils (15) conducteurs sont répartis dans le volume de la matrice (11) diélectrique solide avec une quantité en volume inférieure à 1%.

7. Procédé d'obtention d'un matériau, dit matériau hybride, solide composite **caractérisé en ce qu'**on réalise une dispersion d'une charge inorganique comprenant des nanoparticules (12) filiformes formées d'un matériau inorganique choisi dans le groupe formé des matériaux piézoélectriques, des matériaux pyroélectriques et des matériaux piézoélectriques et pyroélectriques, lesdites nanoparticules (12) filiformes présentant :
o une longueur, s'étendant selon une direction principale d'allongement des nanoparticules (12) filiformes,
o deux dimensions, dites dimensions orthogonales, s'étendant selon deux directions transversales orthogonales entre elles et orthogonales à ladite direction principale d'allongement des nanoparticules (12) filiformes, lesdites dimensions orthogonales étant inférieures à ladite longueur et inférieures à 500 nm, et,
o deux rapports, dits facteurs de forme, entre la longueur et chacune des deux dimensions orthogonales, lesdits facteurs de forme étant supérieur à 10,
dans une composition (2) liquide précurseur d'une matrice (11) diélectrique solide, de façon à obtenir une quantité en volume de nanoparticules (12) filiformes dans ledit matériau hybride inférieure à 50% et de façon que les directions principales d'allongement des nanoparticules (12) filiformes de la charge inorganique répartie dans la matrice (11) diélectrique présentent une distribution sensiblement isotrope dans la matrice (11) diélectrique solide.

8. Procédé selon la revendication 7, **caractérisé en ce que** :
- on réalise une dispersion des nanoparticules (12) filiformes dans un milieu solvant liquide,
- on mélange cette dispersion dans la composition (2) liquide précurseur,
- on élimine le solvant liquide, et,
- on place le matériau hybride dans un champ électrique adapté pour permettre une polarisation des nanoparticules (12) filiformes et leur conversion en nanoparticules (12) filiformes piézoélectriques et/ou pyroélectriques.

9. Procédé selon la revendication 7, **caractérisé en ce que** la matrice (11) diélectrique solide comprenant au moins un matériau polymère, la composition (2) liquide précurseur est une solution dudit matériau polymère dans un solvant liquide choisi parmi le solvant d'une dispersion de nanoparticules (12) filiformes et les solvants miscibles avec le solvant de la dispersion de nanoparticules (12) filiformes.

10. Procédé selon la revendication 7, **caractérisé en ce que** la matrice (11) diélectrique solide comprenant au moins un matériau thermoplastique, la composition (2) liquide précurseur est formée de la matrice (11) diélectrique solide à l'état fondu.

11. Procédé selon la revendication 7, **caractérisé en ce que** la matrice (11) diélectrique solide comprenant au moins un matériau thermodurcissable, la composition (2) liquide précurseur est formée d'au moins une composition liquide entrant dans la composition du matériau thermodurcissable.

12. Utilisation d'un matériau hybride selon l'une des revendications 1 à 6 pour la fabrication de pièces structurelles et de films supportés déposés sur tout ou partie de la surface d'un tel support.

13. Utilisation selon la revendication 12 d'un matériau hybride pour la détection de contraintes mécaniques en surface dudit matériau hybride par effet piézoélectrique direct ou pour la détection de variations de température en surface dudit matériau hybride par effet pyroélectrique direct.

14. Utilisation selon la revendication 12 d'un matériau hybride dans un dispositif choisi dans le groupe formé d'un dispositif audio - notamment un dispositif audio flexible-, d'un dispositif de dégivrage et d'un un dispositif antisalissure mécanique, **caractérisée en ce que** ledit matériau hybride permet la création d'une onde mécanique statique ou dynamique par effet piézoélectrique inverse.

15. Utilisation selon la revendication 12 d'un matériau hybride selon la revendication 6 pour la fabrication d'un matériau isolant phonique adapté pour permettre une absorption d'une onde vibratoire audible et la dissipation de l'énergie de ladite onde vibratoire par effet Joule.

## Patentansprüche

1. Fester piezoelektrischer und/oder pyroelektrischer Verbundwerkstoff, hybrider Werkstoff genannt, der Folgendes umfasst:
- eine feste dielektrische Matrix (11),
- eine anorganische Füllung, die in der festen dielektrischen Matrix (11) verteilt ist, wobei die anorganische Füllung aus einem Werkstoff besteht, der aus der Gruppe ausgewählt ist, die aus den piezoelektrischen Werkstoffen, den pyroelektrischen Werkstoffen und den piezoelektrischen und pyroelektrischen Werkstoffen besteht,
wobei die anorganische Füllung feste Nanopartikel umfasst, fadenförmige Nanopartikel (12) genannt, die Folgendes aufweisen:
- eine Länge, die sich entlang einer Hauptlängsrichtung der fadenförmigen Nanopartikel (12) erstreckt,
- zwei Maße, orthogonale Maße genannt, die sich entlang von zwei transversalen zueinander orthogonalen und zu der Hauptlängsrichtung der fadenförmigen Nanopartikel (12) orthogonalen Richtungen erstrecken, wobei die orthogonalen Maße kleiner sind als die Länge und kleiner als 500 nm, und
- zwei Verhältnisse, Formfaktoren genannt, zwischen der Länge und jedem der zwei orthogonalen Maße, wobei die Formfaktoren größer sind als 10,
wobei
- die fadenförmigen Nanopartikel (12) in dem Volumen der festen dielektrischen Matrix (11) mit einer Volumenmenge verteilt sind, die kleiner ist als 50 %, und dass
- die Hauptlängsrichtungen der fadenförmigen Nanopartikel (12) der anorganischen Füllung, die in der dielektrischen Matrix (11) verteilt ist, eine im Wesentlichen isotrope Verteilung in der festen dielektrischen Matrix (11) aufweisen.

2. Werkstoff nach Anspruch 1, **dadurch gekennzeichnet, dass** die anorganische Füllung im Wesentlichen gleichmäßig in der festen dielektrischen Matrix (11) verteilt ist.

3. Werkstoff nach einem der Ansprüche 1 oder 2, **dadurch gekennzeichnet, dass** die fadenförmigen Nanopartikel (12) aus der Gruppe ausgewählt sind, die aus Nanofäden, Nanostäbchen und Nanoröhrchen besteht.

4. Werkstoff nach einem der Ansprüche 1 bis 3, **dadurch gekennzeichnet, dass** die anorganische Füllung aus einem Werkstoff ausgebildet ist, der aus der Gruppe der anorganischen Keramiken ausgewählt ist.

5. Werkstoff nach einem der Ansprüche 1 bis 4, **dadurch gekennzeichnet, dass** die feste dielektrische Matrix (11) mindestens einen Polymerwerkstoff umfasst, der aus der Gruppe ausgewählt ist, die aus den thermoplastischen Polymerwerkstoffen und den wärmehärtbaren Polymerwerkstoffen besteht.

6. Werkstoff nach einem der Ansprüche 1 bis 5, **dadurch gekennzeichnet, dass** er außerdem eine Füllung, leitende Füllung genannt, aus einem elektrisch leitenden Werkstoff, der leitende Nanofäden (15) umfasst, umfasst, die Folgendes aufweisen:
- eine Länge, die sich entlang einer Hauptlängsrichtung der leitenden Nanofäden (15) erstreckt,
- zwei Maße, orthogonale Maße genannt, die sich entlang von zwei transversalen Richtungen, die sich zueinander orthogonal und orthogonal zu der Hauptlängsrichtung der leitenden Nanofäden (15) erstrecken, wobei die orthogonalen Maße kleiner sind als die Länge und kleiner als 500 nm, und
- zwei Verhältnisse, Formfaktoren genannt, zwischen der Länge und jedem der zwei orthogonalen Maße der leitenden Nanofäden (15), wobei die Formfaktoren größer sind als 50,
bei dem die leitenden Nanofäden (15) in dem Volumen der festen dielektrischen Matrix (11) mit einer Volumenmenge kleiner als 1 % verteilt sind.

7. Verfahren zum Erzielen eines festen Verbundwerkstoffs, hybrider Werkstoff genannt, **dadurch gekennzeichnet, dass** man eine Dispersion einer anorganischen Füllung herstellt, die fadenförmige Nanopartikel (12) umfasst, die aus einem anorganischen Werkstoff ausgebildet sind, der aus der Gruppe ausgewählt ist, die aus den piezoelektrischen Werkstoffen, den pyroelektrischen Werkstoffen und den piezoelektrischen und pyroelektrischen Werkstoffen besteht, wobei die fadenförmigen Nanopartikel (12) Folgendes aufweisen:
- eine Länge, die sich entlang einer Hauptlängsrichtung der fadenförmigen Nanopartikel (12) erstreckt,
- zwei Maße, orthogonale Maße genannt, die sich entlang von zwei transversalen Richtungen, die zueinander orthogonal sind und zu der Hauptlängsrichtung der fadenförmigen Nanopartikel (12) orthogonal sind, erstrecken, wobei die orthogonalen Maße kleiner sind als die Länge und kleiner als 500 nm, und
- zwei Verhältnisse, Formfaktoren genannt, zwischen der Länge und jedem der zwei orthogonalen Maße, wobei die Formfaktoren größer sind als 10,
in einer Vorläuferflüssigkeitszusammensetzung (2) einer festen dielektrischen Matrix 11, so dass eine Volumenmenge fadenförmiger Nanopartikel (12) in dem hybriden Werkstoff kleiner als 50 % erzielt wird, und derart, dass die Hauptlängsrichtungen der fadenförmigen Nanopartikel (12) der anorganischen Füllung, die in der dielektrischen Matrix (11) verteilt ist, eine im Wesentlichen isotrope Verteilung in der festen dielektrischen Matrix (11) aufweisen.

8. Verfahren nach Anspruch 7, **dadurch gekennzeichnet, dass**:
- man eine Dispersion der fadenförmigen Nanopartikel (12) in einem flüssigen Lösemittelmilieu herstellt,
- man diese Dispersion in der Vorläuferflüssigkeitszusammensetzung (2) vermischt,
- man das flüssige Lösemittel eliminiert, und
- man den hybriden Werkstoff in ein elektrisches Feld platziert, das angepasst ist, um eine Polarisation der fadenförmigen Nanopartikel (12) und ihre Umwandlung in piezoelektrische und/oder pyroelektrische fadenförmige Nanopartikel (12) zu erlauben.

9. Verfahren nach Anspruch 7, **dadurch gekennzeichnet, dass** die feste dielektrische Matrix (11) mindestens einen Polymerwerkstoff umfasst, wobei die Vorläuferflüssigkeitszusammensetzung (2) eine Lösung des Polymerwerkstoffs in einem flüssigen Lösemittel ist, das aus dem Lösemittel einer Dispersion fadenförmiger Nanopartikel (12) und den Lösemitteln, die mit dem Lösemittel der Dispersion fadenförmiger Nanopartikel (12) mischbar sind, ausgewählt ist.

10. Verfahren nach Anspruch 7, **dadurch gekennzeichnet, dass** die feste dielektrische Matrix (11) mindestens einen thermoplastischen Werkstoff umfasst, wobei die Vorläuferflüssigkeitszusammensetzung (2) aus der festen dielektrischen Matrix (11) im geschmolzenen Zustand ausgebildet ist.

11. Verfahren nach Anspruch 7, **dadurch gekennzeichnet, dass** die feste dielektrische Matrix (11) mindestens einen wärmehärtbaren Werkstoff umfasst, wobei die Vorläuferflüssigkeitszusammensetzung (2) aus mindestens einer flüssigen Zusammensetzung ausgebildet ist, die zu der Zusammensetzung des wärmehärtbaren Werkstoffs gehört.

12. Verwendung eines hybriden Werkstoffs nach einem der Ansprüche 1 bis 6 zur Fertigung von Strukturteilen und getragener Folien, die auf einen Teil oder die gesamte Oberfläche eines solchen Trägers aufgebracht sind.

13. Verwendung nach Anspruch 12 eines hybriden Werkstoffs für das Erfassen mechanischer Belastungen auf der Oberfläche des hybriden Werkstoffs durch direkten piezoelektrischen Effekt oder zum Erfassen von Temperaturvariationen auf der Oberfläche des hybriden Werkstoffs durch direkten pyroelektrischen Effekt.

14. Verwendung nach Anspruch 12 eines hybriden Werkstoffs in einer Vorrichtung, die aus der Gruppe ausgewählt ist, die aus einer Audiovorrichtung, insbesondere einer flexiblen Audiovorrichtung, einer Enteisungsvorrichtung und einer mechanischen Verschmutzungsschutzvorrichtung ausgebildet ist, **dadurch gekennzeichnet, dass** der hybride Werkstoff das Schaffen einer statischen oder dynamischen mechanischen Welle durch umgekehrten piezoelektrischen Effekt erlaubt.

15. Verwendung nach Anspruch 12 eines hybriden Werkstoffs nach Anspruch 6 zum Fertigen eines Schall dämmenden Werkstoffs, der angepasst ist, um eine Absorption einer hörbaren Schwingungswelle und die Dämpfung der Energie der Schwingungswelle durch Joule-Effekt zu erlauben.

## Claims

1. Piezoelectric and/or pyroelectric composite solid material, called hybrid material, comprising:
- a solid dielectric matrix (11),
- an inorganic filler distributed in the solid dielectric matrix (11), said inorganic filler being composed of a material selected from the group formed of piezoelectric materials, pyroelectric materials, and piezoelectric and pyroelectric materials,
in which said inorganic filler comprises solid nanoparticles, called filiform nanoparticles (12), having:
∘ a length extending in a main direction of elongation of the filiform nanoparticles (12),
o two dimensions, called orthogonal dimensions, extending in two transverse directions which are mutually orthogonal and orthogonal to said main direction of elongation of the filiform nanoparticles (12), said orthogonal dimensions being smaller than said length and smaller than 500 nm, and
∘ two ratios, called aspect ratios, between said length and each of the two orthogonal dimensions, said aspect ratios being greater than 10,
wherein
- said filiform nanoparticles (12) are distributed in the volume of the solid dielectric matrix (11) in an amount by volume of less than 50%, and in that
- the main directions of elongation of the filiform nanoparticles (12) of the inorganic filler distributed in the dielectric matrix (11) have a substantially isotropic distribution in the solid dielectric matrix (11).

2. Maternal according to claim 1, **characterized in that** the inorganic filler is distributed substantially uniformly in the solid dielectric matrix (11).

3. Maternal according to either claim 1 or claim 2, **characterized in that** the filiform nanoparticles (12) are selected from the group formed of nanowires, nanorods and nanotubes.

4. Maternal according to any one of claims 1 to 3, **characterized in that** the inorganic filler is formed of a material selected from the group of the inorganic ceramics.

5. Maternal according to any one of claims 1 to 4, **characterized in that** the solid dielectric matrix (11) comprises at least one polymer material selected from the group formed of thermoplastic polymer materials and thermosetting polymer materials.

6. Maternal according to any one of claims 1 to 5, **characterized in that** it further comprises a filler, called conductive filler, of an electrically conductive material comprising conductive nanowires (15) having:
o a length extending in a main direction of elongation of the conductive nanowires (15),
o two dimensions, called orthogonal dimensions, extending in two transverse directions which are mutually orthogonal and orthogonal to said main direction of elongation of the conductive nanowires (15), said orthogonal dimensions being smaller than said length and smaller than 500 nm, and
o two ratios, called aspect ratios, between said length and each of the two orthogonal dimensions of the conductive nanowires (15), said aspect ratios being greater than 50,
in which said conductive nanowires (15) are distributed in the volume of the solid dielectric matrix (11) in an amount by volume of less than 1%.

7. Method for obtaining a composite solid material, called hybrid material, **characterized in that** there is prepared a dispersion of an inorganic filler comprising filiform nanoparticles (12) formed of an inorganic material selected from the group formed of piezoelectric materials, pyroelectric materials, and piezoelectric and pyroelectric materials, said filiform nanoparticles (12) having:
∘ a length extending in a main direction of elongation of the filiform nanoparticles (12),
∘ two dimensions, called orthogonal dimensions, extending in two transverse directions which are mutually orthogonal and orthogonal to said main direction of elongation of the filiform nanoparticles (12), said orthogonal dimensions being smaller than said length and smaller than 500 nm, and
o two ratios, called aspect ratios, between the length and each of the two orthogonal dimensions, said aspect ratios being greater than 10,
in a liquid precursor composition (2) of a solid dielectric matrix (11), in such a manner as to obtain an amount by volume of filiform nanoparticles (12) in said hybrid material of less than 50% and in such a manner that the main directions of elongation of the filiform nanoparticles (12) of the inorganic filler distributed in the dielectric matrix (11) have a substantially isotropic distribution in the solid dielectric matrix (11).

8. Method according to claim 7, **characterized in that**:
- the dispersion of filiform nanoparticles (12) is prepared in a liquid solvent medium,
- the dispersion is mixed into the liquid precursor composition (2),
- the liquid solvent is removed, and
- the hybrid material is placed in an electric field suitable for permitting polarisation of the filiform nanoparticles (12) and their conversion into piezoelectric and/or pyroelectric filiform nanoparticles (12).

9. Method according to claim 7, **characterized in that**, when the solid dielectric matrix (11) comprises at least one polymer material, the liquid precursor composition (2) is a solution of said polymer material in a liquid solvent selected from the solvent of the dispersion of filiform nanoparticles (12) and solvents that are miscible with the solvent of the dispersion of filiform nanoparticles (12).

10. Method according to claim 7, **characterized in that**, when the solid dielectric matrix (11) comprises at least one thermoplastic material, the liquid precursor composition (2) is formed of the solid dielectric matrix (11) in the molten state.

11. Method according to claim 7, **characterized in that**, when the solid dielectric matrix (11) comprises at least one thermosetting material, the liquid precursor composition (2) is formed of at least one liquid composition involved in the composition of the thermosetting material.

12. Use of a hybrid material according to any one of claims 1 to 6 in the production of structural parts and of supported films deposited on all or part of the surface of such a support.

13. Use according to claim 12 of a hybrid material for the detection of mechanical stresses at the surface of said hybrid material by direct piezoelectric effect or for the detection of temperature variations at the surface of said hybrid material by direct pyroelectric effect.

14. Use according to claim 12 of a hybrid material in a device selected from the group formed by an audio device - especially a flexible audio device, a de-icing device and a mechanical antifouling device, **characterized in that** said hybrid material permits the creation of a static or dynamic mechanical wave by inverse piezoelectric effect.

15. Use according to claim 12 of a hybrid material according to claim 6 in the production of a soundproofing material suitable for permitting absorption of an audible vibrational wave and dissipation of the energy of said vibrational wave by the Joule effect.
